# EUROPEAN PATENT APPLICATION

(11) **EP 2 373 147 A1**
(43) Date of publication of application: **05.10.2011**
(21) Application number: 11156233.6
(22) Date of filing: 28.02.2011
(51) Int. Cl.: H05K 13/04, B23K 1/018

(54) **Repair apparatus and method for electronic component and heat-transfer cap**

(30) Priority: 30.03.2010 JP 2010079175
(71) Applicant: FUJITSU LIMITED, Kawasaki-shi, Kanagawa 211-8588 (JP)
(72) Inventor: Okada, Toru, Kawasaki-shi Kanagawa 211-8588 (JP); Kobayashi, Hiroshi, Kawasaki-shi Kanagawa 211-8588 (JP)
(74) Representative: Lewin, David Nicholas

(57) **Abstract**

A repair apparatus is provided which is configured to melt a solder section of an electronic component to remove the electronic component from a printed wiring board. The repair apparatus includes a light source configured to irradiate light, and a heat-transfer cap including a light-receiving section and a heat-transfer section. The heat-transfer section is configured to contact the electronic component, and transfer a heat generated from the light in the light-receiving section to the electronic component.

## Description

### FIELD

Embodiments discussed herein are related to a repair apparatus, method for an electronic component, and a heat-transfer cap.

### BACKGROUND

Examples of semiconductor packages mounted on a printed wiring board include a ball grid array (BGA) package having a large number of ball-like connection terminals on the bottom of its package board and a chip size package (CSP) (hereinafter referred to as a "package").

For printed wiring boards on which such a package is mounted, the package can be replaced (repaired) in the event of a failure of the package or for the purpose of maintenance or recycling of the package. Therefore, a repair technique for removing the package from the printed wiring board and mounting it again to the printed wiring board is needed.

Japanese Laid-Open Patent Application No. 2006-041375 discusses an example of the repair technique for a repair apparatus that mounts or removes a package to/from a printed board by fusing a solder section of the package for reliably and stably mounting the package to prevent warping or inclination of the package during remounting.

This repair apparatus employs a method involving blowing hot air onto the package to fuse the solder section.

Japanese Laid-Open Patent Application No. 2007-335447 discusses another repair technique that removes electronic components, such as an active device and a passive device, from a printed wiring board by directly irradiating soft beams from a halogen lamp onto the printed wiring board to melt the solder sections of the electronic components mounted on the printed wiring board.

To preclude toxic solder in consideration of environmental problems, there is a tendency to use lead-free solder, such as Sn-Ag-Cu solder containing tin, silver, and copper, for the solder sections. The melting point of the Sn-Ag-Cu solder is about 40°C higher than eutectic solder containing tin and lead. Moreover, the distance between a package mounted in a predetermined region of the printed wiring board and surrounding electronic components is as small as 5 mm to 0.5 mm. Therefore, the method of fusing the solder sections with hot air heats the surrounding electronic components with direct heat from the hot air nozzle and with the heat of hot air that is released to the surroundings after being blown to the package. As a result, the surrounding electronic components are given thermal history that can cause failure. In such a case, the surrounding electronic components can also need to be replaced after completion of repair, which requires additional time for the work. Furthermore, the repair using hot air is complicated involving advance measurement of the temperature history of solder sections using hot air and the temperature history of individual positions around the solder sections, and a determination of the temperature and supply time of the hot air.

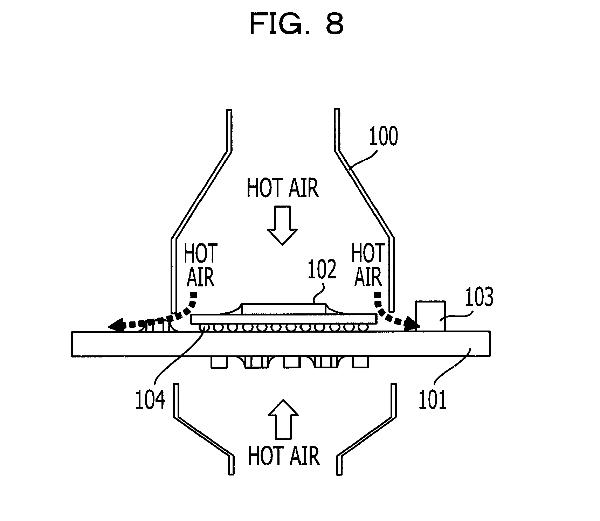

Fig. 8 is a diagram illustrating an example of a method for fusing solder sections with hot air. As shown in Fig. 8, the hot air can be blown against a package 102 placed at a predetermined position of a printed wiring board 101 using a hot air nozzle 100 placed close thereto. The position of the hot air nozzle 100 can be adjusted such that the rim of the opening thereof is, for example, spaced apart about 2 mm from the edge of the package 102, and the opening is located at substantially the same height as that of the upper surface of the package 102. Thus, solder sections 104 at the back of the package 102 can be melted. At that time, the hot air nozzle 100 can discharge the hot air HA to the surroundings of the package 102, as indicated by the broken line arrow in Fig. 8, to ensure the flow of the hot air. An electronic component 103 located in the vicinity of the package 102 can also be heated to a high temperature due to the influence of the heat directly from the hot air nozzle 100 or the heat of the hot air flowing out of the hot air nozzle 100. As a result, a thermal history that will cause a failure of the electronic component 103 can be experienced.

If the method of irradiating direct light is applied to the repair of a package, the solder sections of the package are not uniformly heated, preventing the solder sections from being reliably melted.

### SUMMARY

According to an embodiment of the invention, a repair apparatus is provided that is configured to melt a solder section of an electronic component to remove the electronic component from a printed wiring board. The repair apparatus includes a light source configured to irradiate light, and a heat-transfer cap including a light-receiving section and a heat-transfer section. The heat-transfer section is configured to contact the electronic component, and transfer heat generated from the light in the light-receiving section to the electronic component.

### BRIEF DESCRIPTION OF DRAWINGS

Fig. 1 is a schematic diagram of a repair apparatus according to an embodiment of the invention;

Fig. 2A is a perspective view of a heat-transfer cap, as viewed from the front, for use in the repair apparatus shown in Fig. 1;

Fig. 2B is a perspective view of the heat-transfer cap, as viewed from the back;

Fig. 3A is a diagram illustrating the flow of heat from the heat-transfer cap shown in Figs. 2A and 2B according to an embodiment of the invention;

Fig. 3B is a diagram illustrating an example of the temperature distribution of the heat-transfer cap shown in Figs. 2A and 2B according to an embodiment of the invention;

Fig. 4 is a diagram illustrating the relevant part of a first elevator of the repair apparatus shown in Fig. 1 according to an embodiment of the invention;

Fig. 5 is a control block diagram illustrating control performed by the repair apparatus shown in Fig. 1 according to an embodiment of the invention;

Fig. 6A is an example flowchart of a repair method according to an embodiment of the invention;

Fig. 6B is an example flowchart of a repair method according to an embodiment of the invention;

Fig. 7 is a diagram illustrating measuring points of temperature measurement according to an embodiment of the invention; and

Fig. 8 is a diagram illustrating a repair method using hot air.

### DESCRIPTION OF EMBODIMENTS

Hereinafter, a repair apparatus and method for an electronic component and a heat-transfer cap according to embodiments of the present invention will be described with reference to the attached drawings.

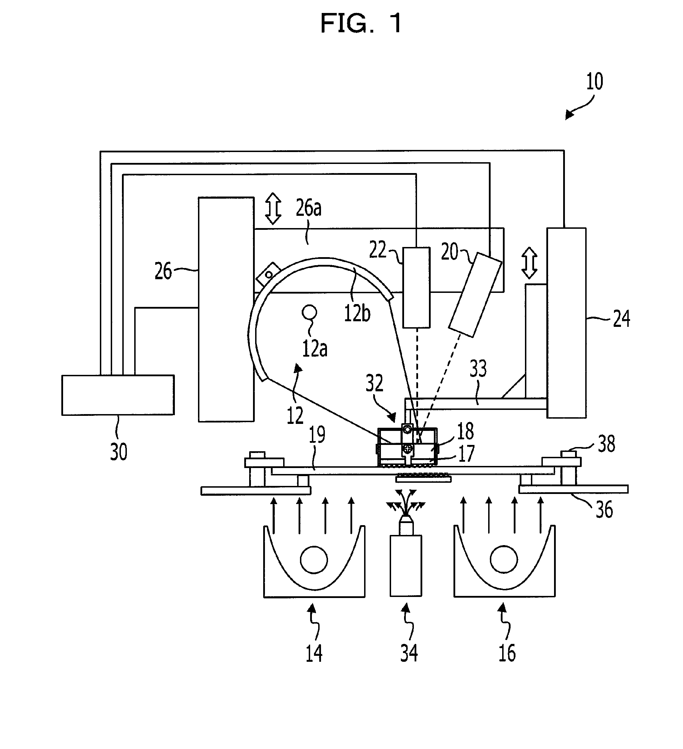

Fig. 1 is a schematic configuration diagram of a repair apparatus 10 according to an embodiment of the invention.

The repair apparatus 10 is an apparatus for melting solder sections of an electronic component disposed at a mount position of a printed wiring board. The repair apparatus 10 is configured to bring a heat-transfer cap heated by irradiation with light beams into contact with the electronic component and transfer heat flowing from the heat-transfer cap to the electronic component through the contact portion. The electronic component can include a package on which semiconductor devices including an active device and a passive device or semiconductor chips are mounted. In the following description, a package of a BGA system (hereinafter referred to as a "BGA package") is used as an example of the electronic component, and a BGA having Sn-Ag-Cu solder (melting point: 220°C) as the solder sections is used as another example of the electronic component.

In accordance with an embodiment of the invention, the repair apparatus 10 can include an upper light-source unit 12, lower light-source units 14 and 16, a heat-transfer cap 18, a temperature measuring unit 20, a displacement measuring unit 22, a first elevator 24, a second elevator 26, a control unit 30, a cap retaining unit 32, a hot-air generating unit 34, a stage 36, and a board holder 38.

The upper light-source unit 12 includes a light source 12a and a reflector 12b. The light source 12a irradiates far-infrared rays (FIR) to the heat-transfer cap 18. Thus, the upper light-source unit 12 heats the heat-transfer cap 18 by radiant energy transfer. The reflector 12b includes a shape that focuses light at a predetermined position. Since the upper light-source unit 12 can be fixed to an arm 26a of the second elevator 26, the upper light-source unit 12 can also be moved as the arm 26a of the second elevator 26 moves. A spot diameter of light focused by the reflector 12b is, for example, about 3 mm. In Fig. 1, the irradiated light flux can be wide.

Examples of the light source 12a include a halogen lamp, a xenon lamp, and a laser light source.

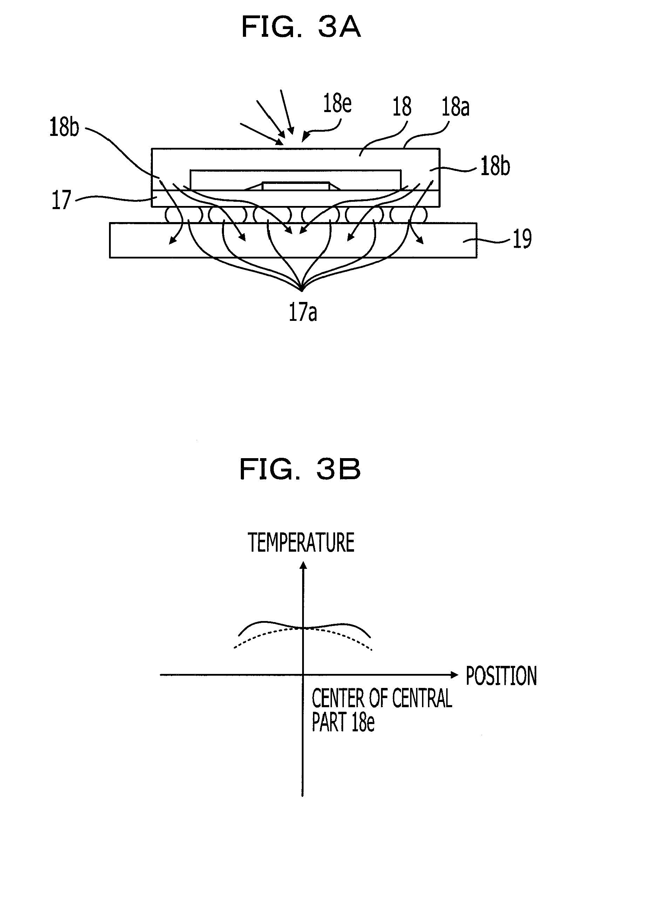

According to an embodiment of the invention, the lower light-source units 14 and 16 irradiate far-infrared light onto the periphery of an opposing portion (hereinafter referred to as a "back side") of the printed wiring board 19 from the BGA package 17 mount position to heat it by radiant energy transfer. This heating is performed to prevent a part of the mount side from being heated by the upper light-source unit 12 to warp the printed wiring board 19 due to thermal expansion. The lower light-source units 14 and 16 uniformly heat the entire wiring board 19 to, for example, about 70°C lower than the melting temperature of solder sections 17a (see Fig. 3A described later). This can reduce the heating time by light irradiation of the upper light-source unit 12. Furthermore, hot air is blown by the hot-air generating unit 34 onto a position of the back side of the printed wiring board 19 corresponding to the BGA package 17 mount position. Thus, the printed wiring board 19 is heated by convective energy transfer.

In an embodiment, the hot-air generating unit 34 blows hot air at, for example, 180 to 220°C onto the printed wiring board 19 from the back side at a flow rate of, for example, 3 to 20 (ml/min). The blowing of hot air is performed to prevent the back side of the mount region of the printed wiring board 19 from becoming hotter than the melting temperature of the solder sections 17a due to the heating by light irradiation of the upper light-source unit 12 and the heating by light irradiation of the lower light-source units 14 and 16. This prevents excessive heating of the back side of the mount position, thereby suppressing an increase in the temperature of the solder sections 17a.

The heat-transfer cap 18 can contact part of the BGA package 17 when the BGA package 17 is placed on the printed wiring board 19.

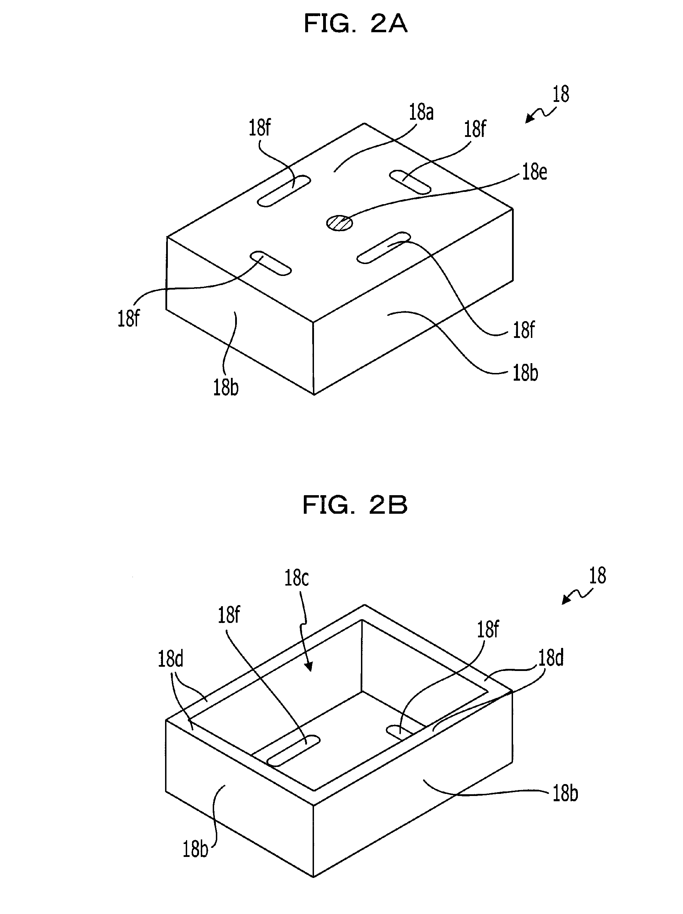

The heat-transfer cap 18 includes a light-receiving section 18a (see Fig. 2A) that is heated by receiving light irradiated from the light source 12a and a heat-transfer section 18b (see Figs. 2A and 2B). The heat-transfer section 18b transfers the heat of the light-receiving section 18a to the BGA package 17, in particular, to the solder sections 17a through a surface in contact with the BGA package 17. The outer periphery of the heat-transfer cap 18 can be substantially the same as the outer periphery of the BGA package 17. The heat-transfer cap 18 is provided with the heat-transfer section 18b so that it can contact the outer edge of the BGA package 17.

Figs. 2A and 2B are perspective views of the heat-transfer cap 18 according to an embodiment of the invention. Fig. 2A is a perspective view of the heat-transfer cap 18, as viewed from the front. Fig. 2B is a perspective view of the heat-transfer cap 18, as viewed from the back.

As shown in Fig. 2A, the heat-transfer cap 18 can be a plate-like member having, at the front, a rectangular plane corresponding to the shape of the BGA package 17 mounted on the printed wiring board 19. As shown in Fig. 2B, the heat-transfer cap 18 includes a recessed portion 18c at the back side of the heat-transfer cap 18. A protruding portion surrounding the recessed portion 18c can contact the BGA package 17 as the heat-transfer section 18b. Thus, the heat-transfer section 18b includes a rectangular-ring-shaped contact surface 18d.

According to an embodiment of the invention, the base material for the heat-transfer cap 18 is a copper material, such as oxygen-free copper and brass, or a high-thermal-conductivity material, such as aluminum, and has a mass as small as, for example, about 1 to 5 g. The heat-transfer cap 18 can be configured such that at least the surface of the light-receiving section 18a is covered with a black chromium oxide coating or a black anodized aluminum coating (anodic oxidation coating) to absorb light energy to become hot by efficiently receiving light and to stabilize temperature measurement, to be described below.

Furthermore, the contact surface 18d of the heat-transfer cap 18 that can come into contact with the BGA package 17 is provided with an adhesive, heat-transfer grease, such as heat-transfer silicone, or a heat-transfer sheet for reducing thermal contact resistance due to the roughness of the surface of the BGA package 17 to achieve efficient heat transfer.

The shape of the heat-transfer cap 18 is determined based on the shape and thermal conductivity of the BGA package 17. When a flip-chip BGA package 17 is to be mounted on the printed wiring board 19, the width of the contact surface 18d of the heat-transfer cap 18 can be set at, for example, 2 to 3 mm. When a resin-sealed wire bonding BGA package 17 is to be mounted on the printed wiring board 19, the width of the contact surface 18d of the heat-transfer cap 18 can be set at, for example, 3 to 4 mm.

Fig. 3A is a diagram illustrating the flow of heat from the heat-transfer cap 18 to the BGA package 17 according to an embodiment of the invention. Fig. 3B is a diagram illustrating an example of the temperature distribution of the light-receiving section 18a of the heat-transfer cap 18 according to an embodiment of the invention. This temperature distribution shows an example of a distribution of temperature of a portion extending along the long side of the rectangular light-receiving section 18a through a central part 18e.

As shown in Fig. 2A, the surface of the light-receiving section 18a at the front of the heat-transfer cap 18 is a rectangular plane, the central part 18e of which is irradiated with substantially converged light. The central part 18e is heated by irradiation with light. In an embodiment, the heat flows toward the heat-transfer section 18b substantially uniformly, which makes the temperature of the solder sections 17a substantially uniform. The back side of the heat-transfer cap 18 is provided with the recessed portion 18c, as shown in Fig. 2B, so that the temperature distribution at the light-receiving section 18a becomes substantially uniform as compared with a case without the recessed portion 18c. The temperature distribution of the light-receiving section 18a is uniform, as indicated by the solid line in Fig. 3B. In contrast, without the recessed portion 18c, the temperature distribution is such that the temperature of the central part 18e is the highest, as indicated by the dotted line, and thus, a uniform heat flow to the heat-transfer section 18b cannot be achieved.

Furthermore, four slit-like small holes 18f formed by cutting the plate-like member along the four sides of the rectangular light-receiving section 18a are provided in the centers of the individual four sides 18b. The small holes 18f are provided to make the temperature distribution of the heat-transfer section 18b more uniform. These small holes 18f pass through the front and back of the heat-transfer cap 18. The small holes 18f include a longitudinal length of about one fourth of each side of the rectangle. Providing such small holes 18f can suppress a decrease in the temperature of the corners of the rectangle. Specifically, when heat flows from the light-receiving section 18a to the heat-transfer section 18b, the corners of the rectangle tend to discharge the heat, thus being prone to a fall in temperature as compared with the surroundings.

Therefore, by blocking heat channels from the central part 18e to the centers of the individual sides with the small holes 18f, a portion of the heat that is to flow from the central part 18e to the centers of the individual sides flows from the central part 18e toward the corners of the rectangle, thus suppressing a decrease in the temperature of the corners.

In accordance with an embodiment of the invention, the temperature measuring unit 20 measures the temperature of the central part 18e of the light-receiving section 18a of the heat-transfer cap 18. The temperature measuring unit 20 measures the temperature by, for example, detecting infrared radiant energy. The result of the temperature measurement is sent to the control unit 30.

The control unit 30 controls the ON/OFF of light irradiation of the light source 12a depending on the result of the temperature measurement sent from the temperature measuring unit 20. Even if the heating temperature is controlled by the ON/OFF control of the light source 12a, the heating temperature for the solder sections 17a varies because the heat-transfer cap 18 is used. Thus, the temperature of the central part 18e of the light-receiving section 18a of the heat-transfer cap 18 can be controlled to a predetermined temperature.

In this embodiment, the temperature of the central part 18e of the light-receiving section 18a, when the solder sections 17a reach a solder melting temperature, can be determined as a target temperature by finding the relationship between the temperature of the central part 18e of the light-receiving section 18a to be measured and the temperature of the solder sections 17a of the BGA package 17 in advance.

In this embodiment, as will be described later, the use of the heat-transfer cap 18 allows the solder sections 17a to be melted while keeping the heating temperature for the central part of the BGA package 17 and the heating temperature for the surrounding electronic components at the upper limit of a heat-resistant temperature or lower. Accordingly, by controlling the temperature of the central part 18e of the light-receiving section 18a to a target temperature, efficient repair can be achieved without exerting thermal effects on the BGA package 17 and the surrounding electronic components.

According to an embodiment of the invention, the displacement measuring unit 22 measures the position of the light-receiving section 18a along a direction perpendicular to the surface of the printed wiring board 19. An example of the displacement measuring unit 22 is a laser displacement meter. When the BGA package 17 is repaired using the heat-transfer cap 18, a small displacement can also occur in the heat-transfer cap 18 when the solder sections 17a melt. Since the mass of the heat-transfer cap 18 is 1 to 5 g, even if the solder sections 17a melt, the melted solder can not be crushed due to the weight of the heat-transfer cap 18.

By detecting a small displacement of the heat-transfer cap 18 during the melting of the solder with the displacement measuring unit 22, the time when the melting of the solder sections 17a is started can be determined. Accordingly, the measurement data of the displacement measuring unit 22 is sent to the control unit 30, and the control unit 30 monitors the presence or absence of a small displacement of the heat-transfer cap 18. The control unit 30 determines the presence or absence of a small displacement of the heat-transfer cap 18 depending on whether the measurement data has exceeded a threshold value. When the control unit 30 determines that a small displacement has occurred, the control unit 30 stops the light irradiation of the light source 12a after a lapse of a predetermined time, for example, about 5 seconds, from the determination time.

In this embodiment, it can be determined by the displacement measuring unit 22 and the control unit 30 whether the solder sections 17a has started to melt. This embodiment eliminates, for example, the work of obtaining information on the heating time until the solder melts, the temperature profiles of the individual portions of the BGA package 17, the temperature profiles of the individual portions of the printed wiring board 19, as in conventional repair apparatuses.

The first elevator 24 is a mechanism for conveying the BGA package 17 and the heat-transfer cap 18 to remove the BGA package 17 from the printed wiring board 19.

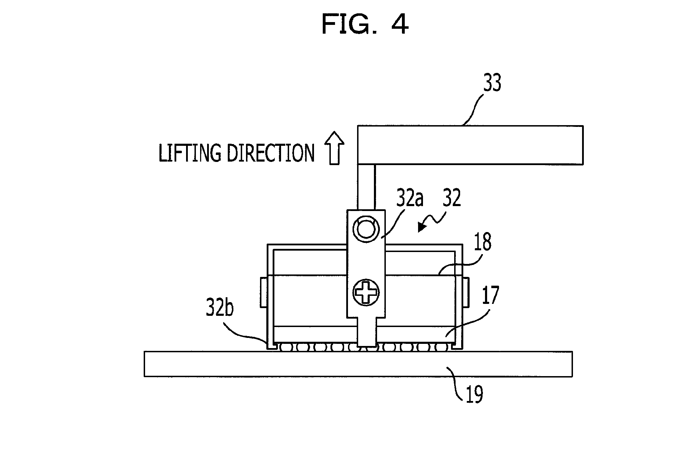

The first elevator 24 includes a holding unit 32 for holding the BGA package 17 and the heat-transfer cap 18, and an arm 33. Fig. 4 is a diagram illustrating the holding unit 32 and the arm 33 in detail according to an embodiment of the invention.

In this embodiment, the holding unit 32 includes a first hook 32a and a second hook 32b. The first hook 32a hooks and lifts the heat-transfer cap 18. The second hook 32b hooks and lifts the BGA package 17. During heating, the displacement of the heat-transfer cap 18 can be measured to determine whether the solder sections 17a has started to melt. Therefore, the first hook 32a and the second hook 32b are not holding the heat-transfer cap 18 and the BGA package 17 during heating.

The arm 33 moves the holding unit 32 in the vertical direction.

The operations of the first hook 32a, the second hook 32b, and the arm 33 are controlled in response to control signals from the control unit 30.

The second elevator 26 is provided to fix the upper light-source unit 12, the temperature measuring unit 20, and the displacement measuring unit 22 to the arm 26a. When the BGA package 17 and the heat-transfer cap 18 are conveyed to the mount position on the printed wiring board 19, the second elevator 26 retracts the upper light-source unit 12, the temperature measuring unit 20, and the displacement measuring unit 22 upward. Thereafter, while light is irradiated to the heat-transfer cap 18, the second elevator 26 moves the upper light-source unit 12, the temperature measuring unit 20, and the displacement measuring unit 22 downward so that the light convergence position comes to the central part 18e of the heat-transfer cap 18.

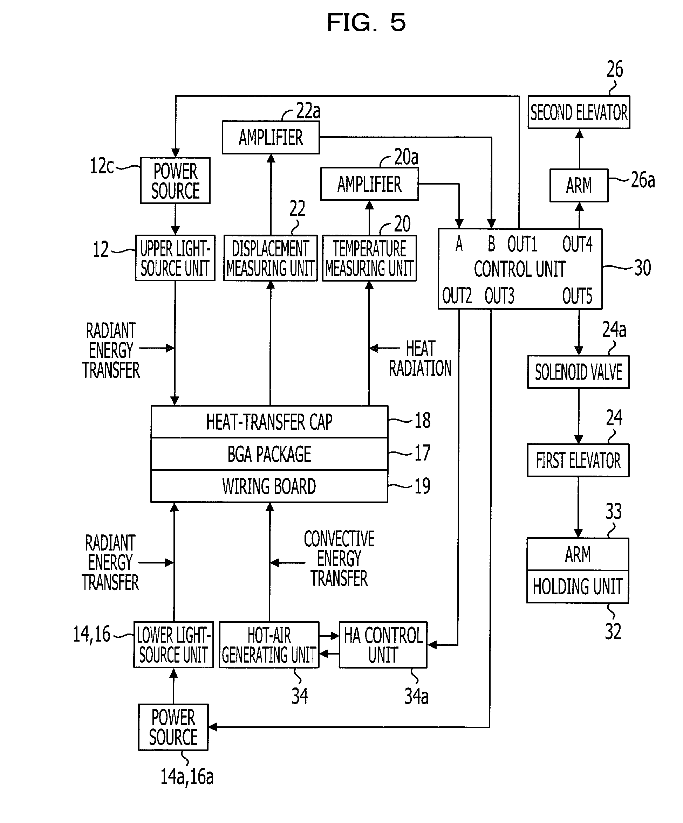

According to an embodiment, the control unit 30 controls the upper light-source unit 12, the lower light-source units 14 and 16, the hot-air generating unit 34, the first elevator 24, and the second elevator 26 based on the measurement data of the temperature measuring unit 20 and the displacement measuring unit 22. Fig. 5 is a control block diagram centered on the control unit 30 according to an embodiment of the invention.

In this embodiment, an amplifier 20a, as shown in Fig. 5, amplifies the temperature data measured by the temperature measuring unit 20 at a predetermined magnification, and if the magnified measurement data exceeds a predetermined threshold value, adjusts the level of the binary signal higher, and if the magnified measurement data does not exceed the threshold value, adjusts the level of the binary signal lower. The amplifier 20a sends the binary signal to the control unit 30. Therefore, the control unit 30 controls the light source 12a so that, when the level of the binary signal changes from 0 to 1, the light source unit 12 is turned off, and when the level of the binary signal changes from 1 to 0, the light source unit 12 is turned on.

In this way, the control unit 30 controls the ON/OFF of the light source unit 12 through a power source 12c based on the level of the binary signal generated by the amplifier 20a. Thus, the heating temperature for the heat-transfer cap 18 can be controlled to a predetermined temperature.

Furthermore, the control unit 30 can detect whether the solder sections 17a have started to melt based on the displacement data measured by the displacement measuring unit 22 and amplified by an amplifier 22a. The heat-transfer cap 18 can be displaced downward when the solder sections 17a are slightly crushed when melting starts. After a lapse of a predetermined time after the start of melting is detected from the displacement of the heat-transfer cap 18, the control unit 30 controls the power sources 12c, 14a, and 16a, and stops the blowing of hot air from the hot-air generating unit 34.

Furthermore, the control unit 30 moves the first elevator 24 by operating a solenoid valve 24a. For example, the control unit 30 controls holding of the BGA package 17 and the heat-transfer cap 18 by the holding unit 32 and lifting of the arm 33.

The control unit 30 moves the second elevator 26 by operating the arm 26a. For example, before the start of heating that is performed to remove the BGA package 17, the holding unit 32 of the first elevator 24 moves to stand by in an unholding state in the vicinity of the BGA package 17. At that time, the control unit 30 retracts the upper light-source unit 12, the temperature measuring unit 20, and the displacement measuring unit 22 through the second elevator 26 to not obstruct the movement of the holding unit 32. Thereafter, the control unit 30 moves the second elevator 26 to move the upper light-source unit 12, the temperature measuring unit 20, and the displacement measuring unit 22 to a predetermined position during heating.

In an embodiment of the invention, the stage 36 positions the printed wiring board 19 so that the mounting position of the printed wiring board 19 is arranged at a predetermined position of the repair apparatus 10. The board holder 38 fixes the located wiring board 19 so that it does not move.

(Repair Method: Mounting)

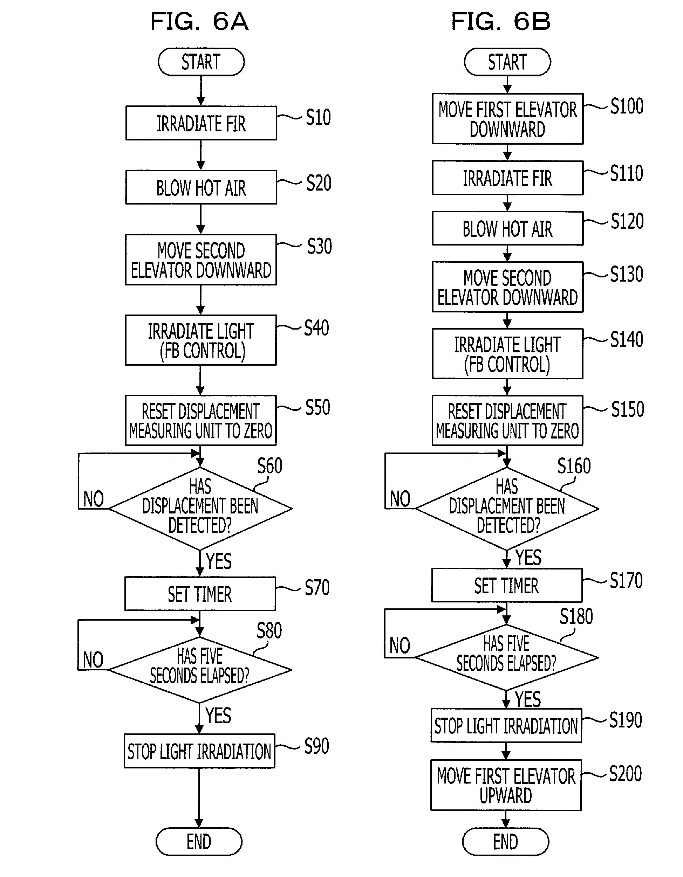

Fig. 6A is an example flowchart of a repair method for mounting the BGA package 17 onto the printed wiring board 19 using the repair apparatus 10 according to an embodiment of the invention.

First, the BGA package 17 and the heat-transfer cap 19 are placed on the mounting position of the printed wiring board 19. Specifically, after the BGA package 17 is placed on the mounting position of the printed wiring board 19, the heat-transfer cap 19 is positioned to fit the outer periphery of the BGA package 17.

Thereafter, the power sources 14a and 16a (see Fig. 5) are turned on in accordance with an instruction of the control unit 30, and the lower light-source units 14 and 16 start irradiation of far-infrared light (FIR) (step S10). Furthermore, the hot-air generating unit 34 starts to blow hot air at, for example, 180 to 220°C onto the printed wiring board 19 through a HA control unit 34a (see Fig. 5) (step S20).

Thereafter, the second elevator 26 moves to move the upper light-source unit 12, the temperature measuring unit 20, and the displacement measuring unit 22 to a predetermined lower position (step S30). Thus, heating by light irradiation is prepared.

Thereafter, the light source 12a is turned on through the power source 12c in accordance with an instruction from the control unit 30 to start irradiation of far-infrared light (FIR), to start the heating of the heat-transfer cap 18 (step S40). Irradiation of far-infrared light (FIR) is feedback-controlled based on measurement data of the temperature measuring unit 20.

Next, the control unit 30 resets measurement data of the displacement measuring unit 22 indicating the current position of the heat-transfer cap 18 to zero to use the measurement data as a reference (step S50). This allows the control unit 30 to monitor the start of melting of the solder sections 17a.

In this state, the control unit 30 stands by until the displacement measuring unit 22 detects displacement of the heat-transfer cap 18 (step S60). Thus, the control unit 30 stands by until the start of melting of the solder sections 17a is detected.

On detection of the start of melting of the solder sections 17a, the control unit 30, according to an embodiment of the invention, sets the timer of the control unit 30 to, for example, five seconds (step S70), and stands by until the timer indicates a lapse of five seconds (step S80). The control unit 30 controls the light irradiation of the light source 12a to OFF after a lapse of the predetermined time (step S90). Thereafter, the heat-transfer cap 18 is removed from the BGA package 17.

The BGA package 17 is now mounted on the printed wiring board 19.

Fig. 6B is an example flowchart of a repair method for removing the BGA package 17 from the printed wiring board 19 using the repair apparatus 10 according to an embodiment of the invention. Since steps S110 to S190 of this method are the same as steps S10 to S90 of the method shown in Fig. 6A, a description thereof will be omitted.

In accordance with this embodiment, when the BGA package 17 is to be removed from the printed wiring board 19, the first elevator 24 moves downward, and the holding unit 32 stands by directly before holding the BGA package 17 and the heat-transfer cap 18 (step S100). The holding unit 32 does not completely hold them in order to monitor the displacement of the heat-transfer cap 18 to determine whether the solder sections 17a has started to melt.

After the solder sections 17a are completely melted, and the light irradiation is turned off in step S190, the control unit 30 controls the holding unit 32 so that the holding unit 32 rapidly holds the BGA package 17 and the heat-transfer cap 18 and that the arm 33 of the first elevator 24 is lifted (step S200).

In this way, the first elevator 24 can rapidly remove the BGA package 17 from the printed wiring board 19 after the solder sections 17a are melted.

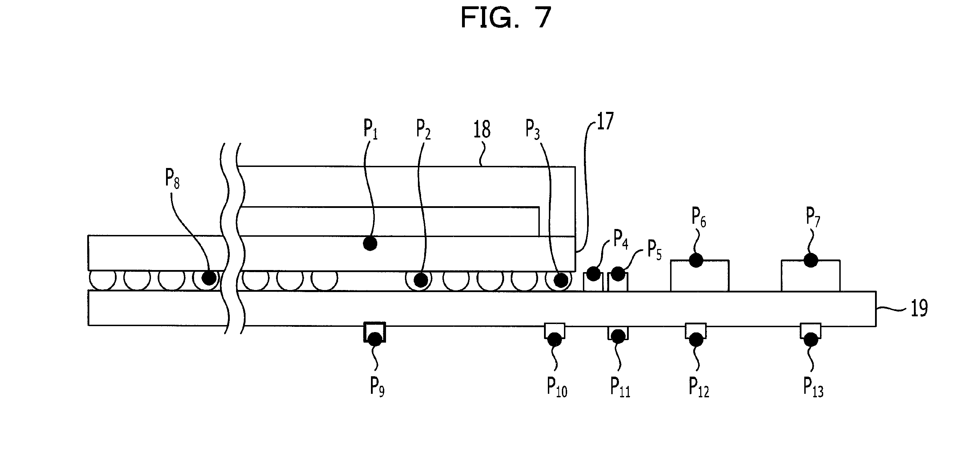

As shown in Fig. 7, when the BGA package 17 is mounted on the printed wiring board 19, the temperature data of the heat-transfer cap 18 heated by irradiation of halogen light is measured. The temperature measurement is performed by providing thermocouples at measuring points P1 to P13.

In accordance with an embodiment of the invention, the measuring point P1 is the center of the BGA package 17 to be mounted. The measuring point P2 is a solder section 17a located at the center of the solder sections 17a of the BGA package 17. The measuring point P3 is a solder section 17a located at the end of the solder sections 17a of the BGA package 17. The measuring point P4 is 0.4 mm spaced apart from the end of the BGA package 17. The measuring point P5 is 1 mm spaced apart from the end of the BGA package 17. The measuring point P6 is 3 mm spaced apart from the end of the BGA package 17. The measuring point P7 is 6 mm spaced apart from the end of the BGA package 17. The measuring point P8 is located at a solder section at the end of an adjacent BGA package that is 1.3 mm spaced apart from the BGA package 17. The measuring points P9 to P13 are located on the back side of the printed wiring board 19 that mounts the BGA package 17. The measuring point P9 is located at a position corresponding to the center of the BGA package 17. The measuring point P10 is located at a position corresponding to the end of the BGA package 17. The measuring point P11 is located at a position corresponding to the measuring point P5. The measuring point P12 is located at a position corresponding to the measuring point P6. The measuring point P13 is located at a position corresponding to the measuring point P7.

As a comparative example 1, temperatures when a BGA package is mounted using hot air are measured, as shown in Fig. 8, with the measuring points P1 to P13 provided with thermocouples.

According to an embodiment of the invention, since a temperature at which the solder sections 17a formed of Sn-Ag-Cu solder melt to allow mounting is 220°C, it is preferable that all of the solder sections 17a be at 220°C or higher and adjacent solder sections and measuring points adjacent to the BGA packages be at 200°C or lower. The temperature of the adjacent measuring points is set to 200°C or lower for preventing solder splash from the adjacent BGA packages and preventing disengagement of the mounted electronic components from the printed wiring board 19. The solder splash is splash of melted solder from solder sections in the vicinity of the inside of underfill of the BGA packages.

The following Table 1 shows temperature measurement data of an embodiment of the invention (hereinafter referred to as a "first embodiment") and the comparative example 1.

As shown in Table 1, in the first embodiment, the temperatures at the measuring point P1 at the center of the BGA package 17 and the measuring points P2 and P3 at the solder sections 17a exceed 220°C, while the temperatures at the other measuring points are less than 200°C. In contrast, in the comparative example 1, the temperatures at the measuring points P4 to P6, in addition to the measuring points P1 and P3, also exceed 220°C, which shows that the temperatures reach the solder melting temperature in the surrounding region other than the BGA package 17 to be mounted. Moreover, the temperature at the measuring point P2, which is a solder section, has not reached 220°C at that time.

This shows that the temperatures of the solder sections 17a of the first embodiment of the invention, as described above, can reach the solder melting temperature more efficiently than the comparative example 1.

**[Table 1]**

| | First Embodiment | Comparative Example 1 |
|---|---|---|
| | [°C] | (hot air) |
| | | [°C] |
| Measuring Point P₁ | 240.2 | 229.1 |
| Measuring Point P₂ | 220.8 | 218.4 |
| Measuring Point P₃ | 221.1 | 224.9 |
| Measuring Point P₄ | 190.2 | 232.6 |
| Measuring Point P₅ | 188.5 | 225.9 |
| Measuring Point P₆ | 159.7 | 221.9 |
| Measuring Point P₇ | 153.6 | 168.4 |
| Measuring Point P₈ | 174.4 | 209.4 |
| Measuring Point P₉ | 198.9 | 219.9 |
| Measuring Point P₁₀ | 173.9 | 215.4 |
| Measuring Point P₁₁ | 168.4 | 199.8 |
| Measuring Point P₁₂ | 167.4 | 188.5 |
| Measuring Point P₁₃ | 164.5 | 174.3 |

In another embodiment (hereinafter referred to as a "second embodiment"), the temperatures of the individual positions are measured using the heat-transfer cap 18 that is heated by irradiation with halogen light when a BGA package 17 different from the BGA package 17 used in the first embodiment is mounted on the printed wiring board 19. The temperature measurement is performed using thermocouples as in the first embodiment and the comparative example 1. The measuring points are the measuring points P1 to P4 and P9, described above, and a measuring point P14. The measuring point P14 is a solder section of another BGA package mounted at the back of the printed wiring board 19 and is located at a position corresponding to the center of the BGA package 17 to be mounted.

The following Table 2 shows the temperature measurement data for the second embodiment and a comparative example 2.

**[Table 2]**

| | Second Embodiment | Comparative Example 2 |
|---|---|---|
| | [°C] | (Direct Light Irradiation on BGA package) |
| | | [°C] |
| Measuring Point P₁ | 238.3 | 251.9 |
| Measuring Point P₂ | 227.2 | 210.5 |
| Measuring Point P₃ | 243.3 | 202.4 |
| Measuring Point P₄ | 192.6 | 164.3 |
| Measuring Point P₉ | 183.7 | 168.0 |
| Measuring Point P₁₄ | 193.6 | 170.8 |

As shown in Table 2, in the comparative example 2, the temperature at the measuring point P1 exceeds 245°C, which is the heat-resistant temperature of the BGA package 17, and the temperatures at the measuring points P2 and P3, which are solder sections, do not reach the solder melting temperature. In contrast, in the second embodiment, the temperature at the measuring point P1 is lower than the heat-resistant temperature, and the temperatures at the measuring points P2 and P3 reach the solder melting temperature, and the temperatures at the measuring points P4, P9, and P14 other than the solder sections 17a do not reach the solder melting temperature, and besides, they are lower than 200°C. This shows that the temperatures of the solder sections 17a of the second embodiment can reach the solder melting temperature more efficiently than the comparative example 2.

All examples and conditional language recited herein are intended for pedagogical objects to aid the reader in understanding the invention and the concepts contributed by the inventors to further the art, and are to be construed as being without limitation to such specifically recited examples and conditions, nor does the organization of such examples in the specification relate to a showing of the superiority and inferiority of the invention. Although the embodiments of the invention have been described in detail, it will be understood by those of ordinary skill in the relevant art that various changes, substitutions, and alterations could be made hereto without departing from the spirit and scope of the invention as set forth in the claims.
The present disclosure extends to the following statements:
1. A repair apparatus configured to melt a solder section of an electronic component to remove the electronic component from a printed wiring board, the repair apparatus comprising:
   a light source configured to irradiate light; and
   a heat-transfer cap comprising a light-receiving section and a heat-transfer section,
   wherein the heat-transfer section is configured to contact the electronic component, and transfer heat generated from the light in the light-receiving section to the electronic component.
2. The repair apparatus according to statement 1, wherein the light-receiving section comprises a plate member disposed away from the electronic component, and the heat-transfer section comprises a leg member protruding from the light-receiving section toward the electronic component.
3. The repair apparatus according to statement 2, wherein the light source is further configured to irradiate light onto a central part of the light-receiving section.
4. The repair apparatus according to any one of statements 1 to 3, wherein the light-receiving section comprises four longitudinal openings disposed along a periphery of the light-receiving section.
5. The repair apparatus according to any one of statements 1 to 4, further comprising:
   a temperature measuring unit configured to measure a temperature of the light-receiving section; and
   a control unit configured to control the light irradiated from the light source based on the temperature of the light-receiving section.
6. The repair apparatus according to any one of statements 1 to 4, further comprising:
   a displacement measuring unit configured to measure a position of the light-receiving section perpendicular to a surface of the printed wiring board; and
   a control unit configured to control the light irradiated from the light source based on the perpendicular position of the light-receiving section.
7. The repair apparatus according to any one of statements 1 to 6, wherein the heat-transfer section comprises a heat-transfer grease or a heat-transfer sheet.
8. The repair apparatus according to any one of statements 1 to 7, wherein the light-receiving section comprises a black chromium oxide or black anodized aluminum coating.
9. The repair apparatus according to any one of statements 1 to 8, wherein the light source is further configured to irradiate far-infrared rays.
10. The repair apparatus according to any one of statements 1 to 9, wherein the light source comprises one of a halogen lamp, a xenon lamp and a laser beam source.
11. A repair method of an electronic component mounted on a printed wiring board, the repair method comprising:
   disposing a heat-transfer cap on the electronic component, wherein the heat-transfer cap comprises a light-receiving section and a heat-transfer section configured to contact the electronic component;
   irradiating light onto the light-receiving section;
   melting a solder section of the electronic component by transferring heat generated from the light in the light-receiving section to the electronic component; and
   removing the electronic component from the printed wiring board.
12. The repair method according to statement 11, further comprising:
   measuring a position of the light-receiving section perpendicular to a surface of the printed wiring board,
   wherein said irradiating the light is stopped after a displacement of the perpendicular position of the light-receiving section is measured.
13. A heat-transfer cap for use in removing an electronic component from a printed wiring board, the heat-transfer cap comprising:
   a light-receiving section configured to receive light from a light source; and
   a heat-transfer section configured to contact the electronic component, and to transfer heat generated from the light in the light-receiving section to the electronic component.
14. The heat-transfer cap according to statement 13, wherein the light-receiving section comprises a plate member disposed away from the electronic component, and the heat-transfer section comprises a leg member protruding from the light-receiving section toward the electronic component.
15. The heat-transfer cap according to statement 13 or 14, wherein the light-receiving section comprises four longitudinal openings disposed along a periphery of the light-receiving section.

## Claims

1. A heat-transfer cap for use in removing an electronic component from a printed wiring board, the heat-transfer cap comprising:
a light-receiving section configured to receive light from a light source; and
a heat-transfer section configured to contact the electronic component, and to transfer heat generated from the light in the light-receiving section to the electronic component.

2. The heat-transfer cap according to claim 1, wherein the light-receiving section comprises a plate member disposed away from the electronic component, and the heat-transfer section comprises a leg member protruding from the light-receiving section toward the electronic component.

3. The heat-transfer cap according to claim 1 or 2, wherein the light-receiving section comprises four longitudinal openings disposed along a periphery of the light-receiving section.

4. A repair apparatus configured to melt a solder section of an electronic component to remove the electronic component from a printed wiring board, the repair apparatus comprising:
a heat-transfer cap as claimed in any of the preceding claims; and
the light source configured to irradiate light.

5. The repair apparatus according to claim 4, wherein the light source is further configured to irradiate light onto a central part of the light-receiving section.

6. The repair apparatus according to claim 4 or 5, further comprising:
a temperature measuring unit configured to measure a temperature of the light-receiving section; and
a control unit configured to control the light irradiated from the light source based on the temperature of the light-receiving section.

7. The repair apparatus according to any one of claims 4 to 6, further comprising:
a displacement measuring unit configured to measure a position of the light-receiving section perpendicular to a surface of the printed wiring board; and
a control unit configured to control the light irradiated from the light source based on the perpendicular position of the light-receiving section.

8. The repair apparatus according to any one of claims 4 to 7, wherein the heat-transfer section comprises a heat-transfer grease or a heat-transfer sheet.

9. The repair apparatus according to any one of claims 4 to 8, wherein the light-receiving section comprises a black chromium oxide or black anodized aluminum coating.

10. The repair apparatus according to any one of claims 4 to 9, wherein the light source is further configured to irradiate far-infrared rays.

11. The repair apparatus according to any one of claims 4 to 10, wherein the light source comprises one of a halogen lamp, a xenon lamp and a laser beam source.

12. A repair method of an electronic component mounted on a printed wiring board, the repair method comprising:
disposing a heat-transfer cap on the electronic component, wherein the heat-transfer cap comprises a light-receiving section and a heat-transfer section configured to contact the electronic component;
irradiating light onto the light-receiving section;
melting a solder section of the electronic component by transferring heat generated from the light in the light-receiving section to the electronic component; and
removing the electronic component from the printed wiring board.

13. The repair method according to claim 12, further comprising:
measuring a position of the light-receiving section perpendicular to a surface of the printed wiring board,
wherein said irradiating the light is stopped after a displacement of the perpendicular position of the light-receiving section is measured.
